Europäisches Patentamt

European Patent Office

Office européen des brevets

(11) Publication number: **0 255 265**
**A2**

## EUROPEAN PATENT APPLICATION

(21) Application number: 87306322.6

(22) Date of filing: 17.07.87

(51) Int. Cl.4: **H01J 37/32** , C23F 4/00

(30) Priority: 30.07.86 GB 8618547

(43) Date of publication of application:
**03.02.88 Bulletin 88/05**

(84) Designated Contracting States:
**DE FR IT NL**

(71) Applicant: **The General Electric Company, p.l.c.:**
**1 Stanhope Gate**
**London W1A 1EH(GB)**

(72) Inventor: **Fortunato, Guglielmo**
**via dell' Annumziatella 33**
**I-00147 Roma(IT)**

(74) Representative: **George, Sidney Arthur**
**The General Electric Company p.l.c., Central**
**Patent Department The Hirst Research**
**Centre**
**Wembley Middlesex, HA9 7PP(GB)**

(54) Plasma etching process and apparatus.

(57) In a plasma etching method, an rf voltage (7) is applied between a pair of electrodes (3, 5) in a discharge chamber (11) so as to excite a low pressure glow discharge in a gas between the electrodes. The reflected rf power from between the electrodes is monitored (7), and the value of the reflected power level is used (9, 13) to determine the etch end point of a film (11) carried on one of the electrodes.

Fig. 1

EP 0 255 265 A2

## Plasma Etching Process and Apparatus

This invention relates to plasma etching processes and apparatus for performing such processes.

Plasma etching processes involve the establishment of an rf low pressure glow discharge from a relatively inert gas. The discharge produces a reactive species which selectively reacts with the film of material previously formed on an underlying layer which is required to etch. This reaction produces a volatile product, which may be removed by pumping such that the film is gradually etched away from the underlying layer.

In some circumstances it is necessary that etching of the underlying layer be minimised. This is achieved by the use of end point determination techniques, which establish the time at which the film has been etched off the underlying layer.

There have been numerous end point determination techniques proposed over the years, a review of such techniques being given in an article by Marcoux and Foo, in Solid State Technology, pages 115 to 112, published in April 1981. Such techniques include emission spectroscopy, mass spectroscopy, optical interferometry, and impedance monitoring. This latter technique was originally proposed in an article by Ukai and Hanazawa in Journal of Vacuum Science Technology, pages 385 -387, published in April 1979. In this article the end point determination of the etching by C Cl₄ of an aluminium film on a silicon wafer is performed by measuring the voltage between the electrodes producing the discharge in order to monitor the impedance of the C Cl₄ discharge. As the impedance of the discharge is found to decrease during the etching of the aluminium film, but return to its original value when the aluminium film is removed, an indication of the time at which the aluminium film is etched off the substrate will be given.

Such an impedance monitoring end point determination technique suffers the disadvantage however that the change in voltage is relatively small, and thus the technique is not very sensitive. Furthermore relatively expensive and complex voltage monitoring equipment must be incorporated in the apparatus performing the etching process. Thus impedance monitoring end point determination techniques have not greatly been used over the years.

It is an object of the present invention to provide a plasma etching process incorporating an impedance monitoring end point determination technique wherein the above disadvantages of impedance monitoring end point determination techniques are at least alleviated, together with a plasma etching apparatus for performing such a process.

According to a first aspect of the present invention a plasma etching process comprises: applying an rf voltage between a pair of electrodes, one of which carries a film to be etched, so as to excite a low pressure glow discharge in a gas between the electrodes; monitoring the reflected rf power from between the electrodes; and using the reflected power level to determine the etch end point.

According to a second aspect of the present invention a plasma etching apparatus comprises: means for applying an rf voltage between a pair of electrodes in a discharge chamber so as to excite a low pressure glow discharge in a gas between the electrodes; means for monitoring the reflected rf power from between the electrodes; and means for using the reflected power level to determine the etch end point of a film carried on one of said electrodes.

Preferably said apparatus has a high Q.

Said means for using said reflected power level suitably includes means for deriving the time derivative of said reflected power level.

Said means for using said reflected power level may suitably incorporate means for tuning said system so as to maintain said reflected power level substantially constant, and means for using any changes in the tuning required to maintain said reflected power level substantially constant to determine said end point.

One plasma etching process in accordance with the invention together with apparatus for performing the process will now be described, by way of example only, with reference to the accompanying figures in which:

Figure 1 is a block schematic diagram of the apparatus;

Figure 2 is the electrical equivalent circuit of the apparatus in use;

Figure 3 shows the reflected power against time characteristic measured during the etching of a polysilicon sample on an oxidised silicon wafer;

Figure 4 shows the time derivative of the reflected power against time characteristic measured during the etching of a polysilicon sample on a glass substrate; and

Figure 5 shows the reflected power against time characteristic measured during the etching of a silicon nitride film on a glas substrate.

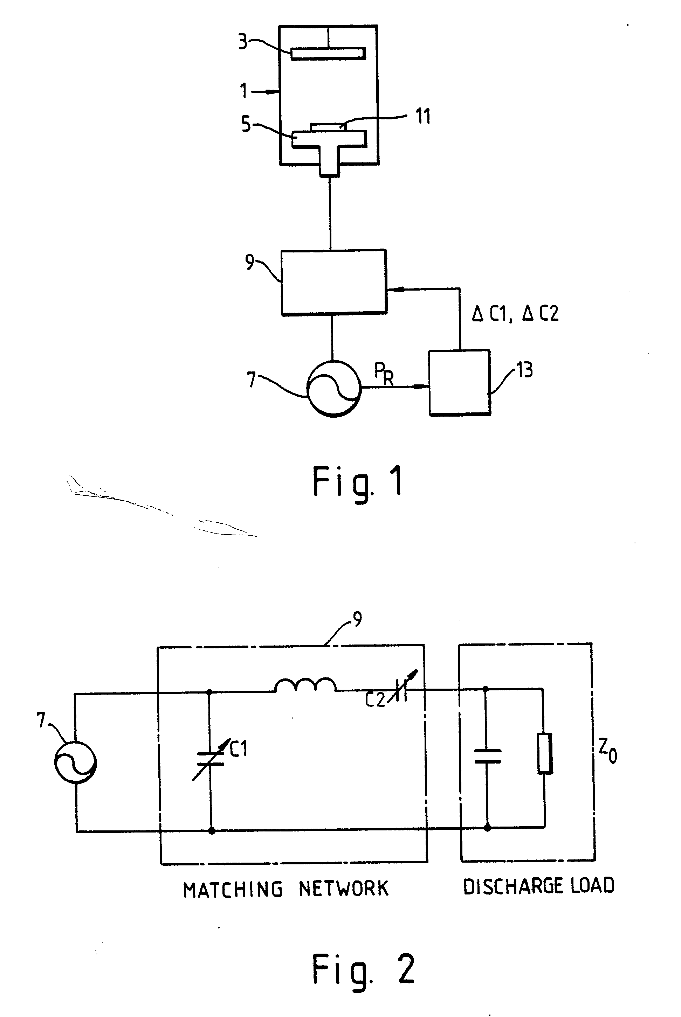

Referring firstly to Figure 1 the apparatus comprises a plasma diode reactive ion etching system. This includes an etching chamber 1 including an earthed electrode 3 and a further watercooled electrode 5. An rf power generator 7 is connected to the electrode 5 via a matching network 9. An appropriate gas manifold (not shown) and pumping stack (also not shown) is provided for introducing gases into, and pumping gases out of the chamber.

In use of the apparatus an etching gas such as $SF_6$ at a pressure of typically 6 Pascals, and a flow rate of typically 30 standard cc/minute is introduced into the chamber 1. An rf voltage of a power of typically 150w at a frequency of 13.56MHz is applied across the electrodes 3,5 such that a discharge is initiated between the electrodes. Referring now also to Figure 2, the discharge impedance $Z_0$ can be matched by adjustment of two variable capacitors C1, C2 within the LC circuit of the matching network 9. By choosing a system with a relatively high Q, very sharp tuning may be achieved, a small change in $Z_0$ thus producing a large change in the reflected power $P_R$ detected by the circuitry incorporated in the generator 7. Tuning of the apparatus is carried out until the reflected power, typically 25w, is stable when the discharge is repeatedly switched on and off.

The rf power is then turned off, and a sample comprising an oxidised silicon wafer substrate 11 carrying a polysilicon film to be etched is introduced into the chamber 1 and a further discharge initiated without further adjustment in the tuning.

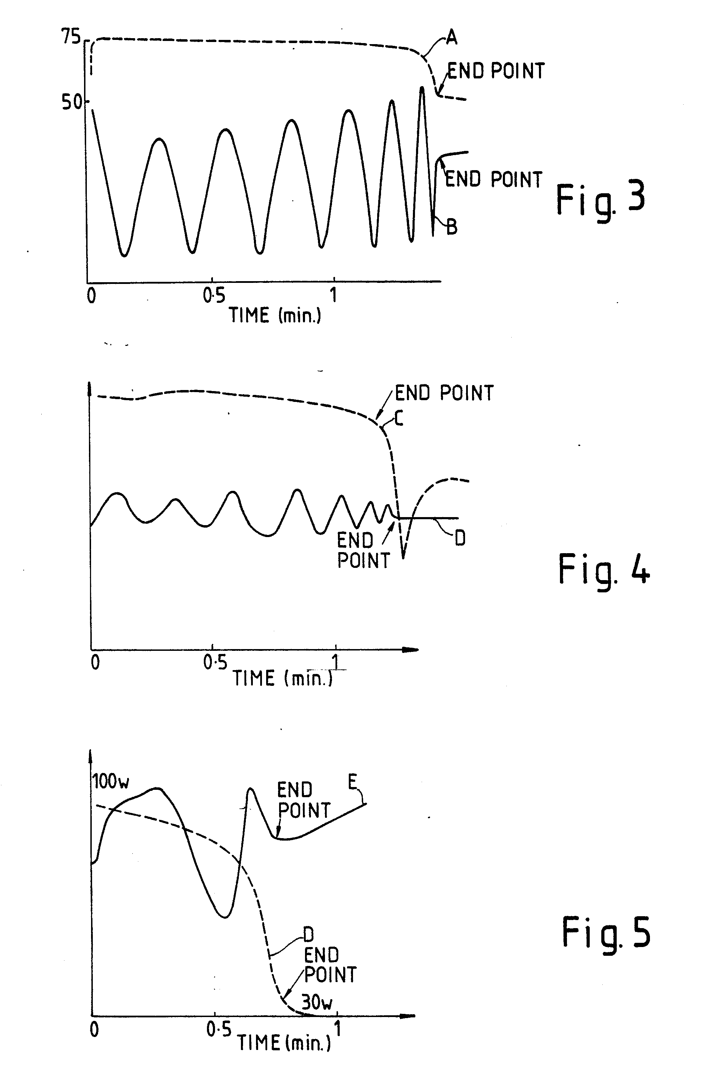

The inventor has found that using the above process, a significant change in the reflected power $P_R$ is observed at the etch end point. This is demonstrated in Figure 3 in which trace A demonstrates the variation in reflected power $P_R$ with time during the etching process, whilst trace B demonstrates the equivalent variation with time of the output signal of a conventional laser end point system in which the interference between laser beams reflected at the upper and lower faces of the film being etched is monitored. As can be seen in this figure, a marked change in the reflected power occurs almost simultaneously with the laser detected end point. This change in reflected power may be attributed to the change in discharge impedance $Z_0$ as part of the etching gas $SF_6$ is converted into $SiF_4$ as the underlying silicon substrate is reached at the end of the etching process.

In contradistinction with known impedance monitoring end point determination methods however an end point determination method in accordance with the invention is simple, and does not involve the use of additional voltage monitoring equipment. The resolution of the technique will be related to the residence time of the $SiF_4$ molecules in the chamber 1 i.e. the mean time which a molecule spends in the chamber 1 before being pumped away. This will typically be 1 second. The technique will, of course, in contrast to the conventional laser end point system be responsive to the average etch end point over the substrate, and furthermore will have greatest sensitivity for large substrate areas making the technique particularly useful for use in production systems in which a large number of substrates are loaded in the apparatus.

It will be appreciated that the above end point determination method in accordance with the invention is readily adaptable for use in an automated system. This would, for example, involve the use of a control system 13 in the apparatus shown in Figure 1 to enable the reflected power $P_R$ to be kept constant. The necessary adjustment in the values of C1 and C2 i.e. $\Delta$ C1 and $\Delta$ C2 to enable such automatic matching would then be monitored to enable the end point to be determined.

Referring now also to Figure 4, the sensitivity of the technique may be greatly enhanced by monitoring the time derivative of the reflected power $P_R$ as a function of time. Trace C of Figure 4 shows the time variation of the time derivative of the reflected power for the etching of a sample comprising a polysilicon film on a glass substrate under similar circumstances to those of the first sample. Trade D agains shows the equivalent variation with time of the lase end point signal. As can be seen from this figure, there is a very sharp change in slope in trace C at the end point.

It will be appreciated processes and apparatus in accordance with the invention may be used for the determining of the etch end point for films other than those of polysilicon. One such example is shown in Figure 5 where Trace E shows the variation in reflected power wth time for a silicon nitride film on a glass substrate, trace F showing the equivalent laser end point signal.

It will also be appreciated that the technique is applicable to etching gases other than $SF_6$, for example $CF_4$ and $C Cl_4$.

**Claims**

1. A plasma etching process for etching a film, characterised by mounting the film (11) on one of a pair of electrodes (3, 5); applying an rf voltage between the pair of electrodes so as to excite a low pressure glow discharge in a gas between the electrodes; monitoring rf power reflected from between the electrodes; and using the level of the reflected power to determine the end point of the etching process.

2. Plasma etching apparatus, characterised by means (7) for applying an rf voltage between a pair of electrodes (3, 5) in a discharge chamber (1) so as to excite a low pressure glow discharge in a gas between the electrodes; means (7) to monitor the level of rf power reflected from between the electrodes; and means (13) to use the reflected power level to determine the etch end point of a film carried on one of said electrodes.

3. Apparatus according to Claim 2, characterised in that the apparatus has a high Q.

4. Apparatus according to Claim 2 or Claim 3, characterised in that the means (13) to use the reflected power level includes means to derive the time derivative of the reflected power level.

5. Apparatus according to any one of Claims 2 to 4, characterised in that the means (13) to use the reflected power level incorporates means for tuning the apparatus so as to maintain the reflected power level substantially constant; and means to use any changes in the tuning required to maintain the reflected power level substantially constant to determine said end point.

Fig. 1

MATCHING NETWORK    DISCHARGE LOAD

Fig. 2

Fig. 3

Fig. 4

Fig. 5